(19) Europäisches Patentamt
European Patent Office
Office européen des brevets

(11) EP 1 600 977 B1

(12) **EUROPEAN PATENT SPECIFICATION**

(45) Date of publication and mention
of the grant of the patent:
**20.02.2008 Bulletin 2008/08**

(51) Int Cl.:
*G11C 11/16* (2006.01)    *G11C 11/56* (2006.01)

(21) Application number: **05253146.4**

(22) Date of filing: **20.05.2005**

(54) **Multi-bit magnetic random acces memory device**

Magnetische Multibit-Speicherzellenvorrichtung mit wahlfreiem Zugriff

Dispositif mémoire multibit magnétique à accès aléatoire

(84) Designated Contracting States:
**DE FR**

(30) Priority: **21.05.2004 KR 2004036380**
**13.07.2004 US 587084 P**
**29.04.2005 US 117352**

(43) Date of publication of application:
**30.11.2005 Bulletin 2005/48**

(60) Divisional application:
**07122006.5 / 1 890 296**

(73) Proprietor: **SAMSUNG ELECTRONICS CO., LTD.**
**Suwon-si,**
**Gyeonggi-do (KR)**

(72) Inventor: **Lim, Chee-kheng**
**Yeongtong-gu,**
**Suwon-si,**
**Gyeonggi-do (KR)**

(74) Representative: **Greene, Simon Kenneth**
**Elkington and Fife LLP**
**Prospect House**
**8 Pembroke Road**
**Sevenoaks,**
**Kent TN13 1XR (GB)**

(56) References cited:
**US-A1- 2002 175 386      US-A1- 2003 185 045**
**US-A1- 2004 076 036      US-A1- 2004 090 844**
**US-B1- 6 717 843**

**Description**

The present invention relates to magnetic random access memory, and more particularly to a multi-bit magnetic random access memory device and a method for writing to and for sensing the multi-bit magnetic random access memory device.

Rapid growth in digital information generation is likely to face a new wave of explosion in high density memory demand due to the growing popularity of mobile devices. Magnetic random access memory (MRAM) is one of the most promising candidates to provide energy efficient and non-volatile memories.

The most attractive advantages of MRAM are that the mobile device retains the current state of work when powered down, and, additionally, longer battery run-times can be provided for mobile devices from notebook computers to cell-phones, since non-volatility enables MRAM chips to consume less power than conventional Dynamic Random Access Memory (DRAM) and Static Random Access Memory (SRAM).

The building block of the MRAM architecture is its crossed-wires structure, where a magnetic element is located at the intersection point of two orthogonal wires. The writing or addressing process of an MRAM cell is accomplished by applying two orthogonal magnetic field pulses, generated by sending an electrical current, down the wires. The two wires are often referred to as the word line (Hy field, along the short axis of the magnetic element) and the bit line (Hx field, along the long axis (or easy axis) of the magnetic element).

The strength of the magnetic fields applied are such that one field alone cannot switch the magnetization of a magnetic element, but rather it requires the combination of both magnetic fields from the word and bit lines, for cell selectivity. However, the present cell writing technology relies on applying a long magnetic field pulse, tens of nanoseconds, long enough for the magnetization to reach the final equilibrium state. This method of writing is also known as the quasistatic writing which is not only slow but also not energy efficient.

Also, in such a memory having a multilayer cell structure, there is a limitation of memory density. In most cases, only one bit of information can be stored at the cross-point (the intersection point of the two orthogonal wires) in the MRAM architecture.

Recent attempts have been made to overcome this limitation of memory density. For example, U.S. Patent Publication 2003/0209769 to Nickel et al. discloses an MRAM device having a multi-bit memory cell. In particular, each memory cell includes two magnetoresistive devices connected in series.

Each of the two magneto-resistive devices has sense layers with distinctly different coercivities and, therefore, requires different writing currents. Thus, write operations can be performed selectively on the two magneto-resistive devices. Each multi-bit memory cell has four logic states with different resistance values in each state. This allows for storage of more data than a related art single-bit memory cell, which has only two logic states.

U.S. Patent No. 5,930,164 to Zhu also discloses a magnetic memory device having four logic states and an operating method thereof The memory device of Zhu includes a multi-bit system accomplished by stacking two or more memory cells on top of each other separated by a thick conductive layer to prevent magnetic coupling between memory cells.

In Zhu, each memory cell comprises a free magnetic data layer to store one bit of information, a hard magnetic layer as a reference layer, and a barrier layer between the free and hard magnetic layer. Essentially, each memory cell is an independent MTJ device. The memory cells have distinct coercivities, therefore allowing independent cell writing by one or two magnetic fields. For sensing or reading process, these memory cells have different Magnetoresistance (MR) ratios, therefore creating four resistance states for sensing of multi-bit information. The writing method, however, relies on a quasistatic writing method which is not only slow, but also not energy efficient.

U.S. Patent No. 5,703,805 to Tehrani et al. discloses a method for detecting information stored in an MRAM cell having two magnetic layers with different thicknesses.

In the Tehrani et al. device, there are two magnetic data layers separated by a non-magnetic spacer. Each magnetic data layer can store one bit of information. A writing process for this device uses differing coercive forces for the two magnetic data layers, hence, independent writing is possible using a quasistatic method. A quasistatic writing method relies on applying a long magnetic field pulse of several nanoseconds that is long enough for the magnetization of a cell to reach a final equilibrium state. As noted above, this method of switching is not only slow, but also not energy efficient.

Further, the reading process of the Tehrani et al. device is very complex since six magnetic fields are required to determine the state in each data layer separately. This creates a slow and inefficient reading process.

Finally, U.S. Patent No. 6,590,806 to Bhattacharyya discloses a device having two magnetic data layers separated by a pair of antiferromagnetically coupled magnetic layers. The two free magnetic data layers have distinct coercivities and hence, independent writing is possible.

The Bhattacharyya device has four resistance states depending on the magnetic configuration of the free data layers to the antiferromagnetically coupled layers. Therefore, the reference layer for the magnetoresistance effect is the pair of antiferromagnetic coupled layers. This means that if this device is to be used for additional data layers, each data layer requires one pair of antiferromagnetic layers, providing for a complicated device structure. Also, the device relies on the conventional quasistatic writing method.

Further, the manufacturing process of related art MRAM devices has only been known to produce low yields of the memory due to high sensitivity to cell defects, which causes domain nucleation, and hence, wide switching field distribution.

US 2004/0090844 describes a multiple level magnetic memory cell having first and second magneto-resistive devices connected in series. The devices have sense layers with different coercivities. Arrays of these cells are described. The resistant states of the cell may be selected so that each of the four possible logic states from the two layers can be distinguished from the resistance.

US 2002/0175386 describes another MRAM. A transistor is provided in a lower layer and the MRAM in an upper layer.

US 6,717,843 describes a multilevel MRAM which has 2, and in embodiments more, magnetic layers.

US 2004/0076036 describes a particular MRAM cell which in embodiments uses spin polarized electrons to write to the memory cell.

US 2004/0185045 describes writing methods for operating an MRAM, and in particular a method in which a magnetic field is applied in one direction for a longer time, and a magnetic field is applied in the perpendicular direction in alternating directions for a shorter time.

According to an aspect of the invention, there are provided writing methods for a magnetic memory according to claim 1.

According to another aspect of the invention, there is provided a Magnetic Random Access Memory (MRAM) according to claim 24.

The present invention provides a multi-bit MRAM increasing integration, enabling high-speed recording, reducing an effect of a size deviation of a magnetic tunneling junction (MTJ) cell.

The present invention also provides methods of operating and sensing the multi-bit MRAM.

The multi-bit MRAM device disclosed in exemplary embodiments herein is a magnetoresistance memory device designed to store more than one bit of information at one intersection between the bit and word lines. In one exemplary embodiment, two independent information bits are stored in two magnetically changeable ferromagnetic layers where each layer holds a single bit of binary information.

Of course, memory cells have holding more than two bits of information are also disclosed, and one of ordinary skill in the art will recognize that multiple bit cells may be realized using the same principles as for the two bit cell.

More particularly, in one exemplary embodiment of the invention, the MRAM comprises a switching device, a magnetic recording medium connected to the switching device, a first magnetic field generating unit installed between the switching device and the magnetic recording medium, and a second magnetic field generating unit connected to the magnetic recording medium, wherein the magnetic recording medium comprises upper and lower magnetic layers that are magnetically changeable and are sequentially stacked on a pinned layer having a fixed magnetization direction, a lower spacer formed between the pinned layer and the lower magnetic layer, and an upper spacer formed between the upper and lower magnetic layers, wherein a difference $\Delta R1$ between maximum and minimum resistances of a stack of the pinned layer, the lower spacer, and the lower magnetic layer is different from a difference $\Delta R2$ between maximum and minimum resistances of a stack of the lower magnetic layer, the upper spacer, and the upper magnetic layer.

The MRAM may further comprise a third magnetic layer on the upper magnetic layer, wherein the upper and third magnetic layers are separated from one another by a third spacer layer.

The upper and lower magnetic layers may has differing spin precession frequencies.

The upper and lower magnetic layers may has a differing ferromagnetic material, a differing thickness or a differing magnetocrystalline anisotropy.

The upper and lower magnetic layers may comprise one of an in-plane magnetocrystalline anisotropy, an out-of-plane magnetocrystalline anisotropy, and a combination of an in-plane magnetocrystalline anisotropy and an out-of-plane magnetocrystalline anisotropy.

The upper and lower magnetic layers may comprise an alloy of Ni, Fe and Co, or a combination thereof.

The each of the upper and lower magnetic layers may stores one bit of binary information.

A cell formed by the magnetic and spacer layers may include rounded ends for suppressing magnetic domain nucleation.

A cell formed by the magnetic and spacer layers may have as aspect ratio in a range of about 1.1 and 5.0.

The upper and lower magnetic layers may have different saturated magnetizations.

The upper and lower magnetic layers may be identical magnetic material layers, wherein a capping layer increasing the Gilbert's decay constant is formed on the upper magnetic layer.

The upper and lower spacers may have different thicknesses.

The upper and lower spacers may be formed of different materials.

The upper and lower spacers may have different saturated magnetizations.

The upper and lower magnetic layers may have different magnetic anisotropies.

The third spacer may be formed of a conductive material, a non-conductive material, or a mixture of the forgoing materials.

The upper magnetic layer, the lower magnetic layer, and the third magnetic layer may have different saturated magnetizations.

The MRAM may comprise a capping layer increasing the Gilbert's decay constant on the third magnetic layer.

The first magnetic field generating unit may be a data line and the second magnetic field generating unit may be a bit line.

The upper and lower magnetic layers may be magnetic material layers causing vertical magnetization.

The upper magnetic layer, the lower magnetic layer, and the third magnetic layer may be magnetic material layers causing vertical magnetization.

The MRAM may comprise a filter generating spin polarization current in or on the magnetic recording medium.

In an exemplary embodiment, the present invention provides a writing method for the MRAM including a switching device and the magnetic recording medium which is connected to the switching device and includes a magnetic layer to which bit data are written, wherein bit data are written to the magnetic recording medium by applying an external magnetic pulse including an easy axial direction magnetic pulse (Hx) and a hard axial direction magnetic pulse (Hy).

The magnetic recording medium may comprise the upper and lower magnetic layers having different spin precession frequencies.

The intensity of the easy axial direction magnetic pulse (Hx) may be varied while the intensity of the hard axial direction magnetic pulse (Hy) is maintained constant.

The external magnetic pulse having an intensity ratio of the easy axial direction magnetic pulse (Hx) to the hard axial direction magnetic pulse (Hy) that is smaller than 1 may be applied to the magnetic recording medium.

The hard axial direction magnetic pulse (Hy) may be applied for a shorter duration than the easy axial direction magnetic pulse (Hx).

The external magnetic pulse including an easy axial direction magnetic pulse (Hx) and a hard axial direction magnetic pulse (Hy) that have an equal intensity may be applied to the magnetic recording medium.

Multi-bit data may be selectively written to the magnetic recording medium by applying a first external magnetic pulse including an easy axial direction magnetic pulse (Hx) and an hard axial direction magnetic pulse (Hy) that have an equal intensity and applying a second external magnetic pulse including an hard axial direction magnetic pulse (Hy) and an easy axial direction magnetic pulse (Hx) that has a smaller intensity than the hard axial direction magnetic pulse (Hy) therein.

Assuming that a period of spin procession of electrons in the lower magnetic layer when the external magnetic pulse is applied is T1, the hard axial direction magnetic pulse (Hy) may be applied for a duration of $(n+1/2)T1$ where n is an integer.

Assuming that a period of spin procession of electrons in the upper magnetic layer when the external magnetic pulse is applied is T2, the hard axial direction magnetic pulse (Hy) may be applied for duration of $nT2$ where n is an integer.

In another exemplary embodiment, the present invention provides a writing method for a magnetic random access memory including a switching device and the magnetic recording medium which is connected to the switching device and includes upper and lower magnetic layers having different spin precession frequencies to which bit data are written and a spacer between the upper and lower magnetic layers, wherein bit data are written to one of the upper and lower magnetic layers by applying spin polarization current to the magnetic recording medium.

A writing method for a magnetic memory comprising a memory cell comprising at least upper and lower magnetic layers, and a magnetic reference layer, the method defining a writing event comprises applying a first magnetic field below a switching field along a long axis of the memory cell; and applying a second magnetic field orthogonal to the first magnetic field, wherein the first magnetic field is turned-off after the second magnetic field is turned-off.

In this case, a pulse of the first magnetic field may have a longer duration than a pulse of the second magnetic field.

The first and second magnetically changeable ferromagnetic layers may be independently written using a single writing event.

A pulse of the second magnetic field may have a rise time which is equal to or less than 1 ns.

The upper magnetic layer may have a damping constant greater than the damping constant of the lower magnetic layer such that a writing response time of the upper magnetic layer is delayed to accomplish independent writing.

The pulse of the magnetic fields may be shaped to generate a fast rising field to create a rise time that activates spin precession. Also, the pulse of the magnetic fields may be shaped in one of a trapezoidal or exponential shape.

The method may further comprise sensing stored information in each of the upper and lower magnetic layers using a magnetoresistance effect

The method may further comprise terminating the second magnetic field when the magnetization of the upper magnetic layer has been through $(n + 1/2)$ precession cycles, where n is a number of precession cycles.

A pulse duration of the first magnetic field may be in a range of 0.2 to 10 ns, while a pulse duration of the second magnetic field is in a range of 0.01 to 5 ns.

The method may further comprise controlling at least one of a saturation magnetization and magnetic anisotropy ratio of the upper and lower magnetic layers to achieve independent writing.

The upper and lower magnetic layers and the upper spacer as a structure may have a differing MR ratio than a structure including the lower magnetic layer, the lower spacer, and the reference layer.

The upper and lower magnetic layers may be written as (1,1) and (0,0) using a single writing event, and (1,0) and (0,1) using two writing events.

The upper and lower magnetic layers may be written as (1,0) by first writing "1" in both of the upper and lower magnetic layers, followed by a second writing event to write "0" in the magnetically softer magnetic layer.

The upper and lower magnetic layers may be written as (0,1) by first writing "0" in both the upper and lower magnetic layers, followed by a second writing event to write "1" in the magnetically softer magnetic layer.

The method may further comprise inducing orthogonal unidirectional anisotropy in one of the upper and lower magnetic layers.

The method may further comprise setting a magnetization pinning axis of the reference layer orthogonal to the long axis of the memory cell.

In a still exemplary embodiment, the present invention provides a sensing method for a device as the above described MRAM, wherein selective writing of the upper and lower magnetic layers is performed using a combination of a saturation magnetization ratio, magnetic isotropy ratio, easy to hard axis field magnitude ratio, and/or a spin polarized current density ratio.

When the upper and lower magnetic layers are in a (1, 1) configuration, a readback signal may be different from a (0,0) configuration by a magnetoresistance ratio of a structure including the lower magnetic layer, the lower spacer, and the reference layer.

When the upper and lower magnetic layers are in a (1, 0) configuration, a readback signal may be different from a (0,0) configuration by a magnetoresistance ratio of a structure including the upper and lower magnetic layers and the upper spacer.

When the upper and lower magnetic layers are in a (0, 1) configuration, a readback signal may be different from a (0,0) configuration by the sum of magnetoresistance ratios of a first structure including the lower magnetic layer, the lower spacer, and the reference layer and a second structure including the upper and lower magnetic layers and the upper spacer.

The sensing method may further comprising increasing readback signal states by increasing a difference between a magnetoresistance ratio of a first structure including the lower magnetic layer, the lower spacer, and the reference layer and a magnetoresistance ratio of a second structure including the upper and lower magnetic layers and the upper spacer.

The writing scheme disclosed in an exemplary embodiment of the invention uses the spin precessional nature of ferromagnetic material in which an easy axis magnetic field (+Hx or -Hx) used to define the final state of the memory (1 or 0) is combined with an orthogonal hard axis excitation field (+Hy or -Hy) to initiate spin precession. In this switching process, neither the Hx field nor the Hy field alone is able to switch the magnetization. Rather, the combination of the Hx and Hy fields is the essence of selective writing in the memory array. Spin precessional switching as used in an exemplary embodiment of the present invention uses a fast Hy field, in the order of 1ns or less.

In another exemplary embodiment of the invention, the Hy excitation field pulse is required to have a very short rise time (< 1.0 ns), and pulse duration is of the half the magnetic spin precession period.

Ultra-fast magnetization switching dynamics is governed by the damped precession of magnetization about an effective magnetic field, $H_{eff}$. The effective magnetic field $H_{eff}$ is the sum of the applied fields and the magnetic anisotropy field of the memory cell which is dominated by the shape anisotropy.

The motion of magnetization M is described by the Landau-Liftshitz-Gilbert (LLG) equation, $dM/dt = -\gamma (M \times H_{eff}) + (\alpha / Ms)(M \times dM/dt)$, where M is the magnetization vector, $\gamma$ is the gyro-magnetic constant, $\alpha$ is the phenomenological Gilbert damping constant, and Ms is the saturation magnetization. In the case of MRAM, the effective magnetic field is the vector sum of the Hx and Hy.

A fast rising magnetic field pulse applied orthogonal to the M direction will generate a large torque, $\gamma (M \times H_{eff})$. As a result, M is excited into precession around the effective field direction. The first term in the LLG equation is the precession term, which describes the spin precession, and the second term is the energy dissipation term that dictates the rate of energy dissipation. Adapting spin precessional switching promises high-energy efficiency as well as an ultrafast switching speed.

One of the most important natures in precessional switching of the invention is that the precession frequency f depends on the effective magnetization and effective applied magnetic field It can be expressed as $f^2 (\gamma/2\pi)^2 (H_{eff} + M_{eff}) + H_{eff}$, where $\gamma = 28$ GHz/T. This is also known in the art as the Kittel formula. The equation leads to the fact that it is possible to manipulate the spin precession frequency by controlling the effective magnetization and effective field experienced by the spin.

The second magnetic field is turned-off as soon as the magnetization of the one cell has precessed to more than about 1/2 but less than about 3/4 of the precession cycle. The first magnetic field is kept constant for a certain time duration (> 0.5 ns) after the second magnetic field is turned-off, or in other words, the magnetic field duration of Hy is always shorter than Hx.

In this exemplary embodiment, the first magnetic field is applied along the horizontal axis and is used to define the final magnetization state of the ceU intended for switching. The second magnetic field is referred to as the spin precessional excitation field (along the word line).

The above aspects of the present invention will become more apparent by describing in detail exemplary embodiments thereof with reference to the attached drawings in which:

FIG. 1 is a cross-sectional view of a multi-bit MRAM according to an embodiment of the present invention;

FIG. 2 schematically illustrates a memory according to an exemplary embodiment the present invention;

FIGS. 3 and 4 are views illustrating a spin precession of an electron of a magnetic layer of a magnetic recording medium shown in FIG. 1 with respect to an effective magnetic field;

FIG. 5 is a vibration graph 2-dimensionally illustrating a spin precession of an electron of a magnetic field of a magnetic recording medium shown in FIG. 2;

FIG. 6 is a graph illustrating a reaction of the electron of the magnetic layer of the magnetic recording medium shown in FIG. 2 with respect to an effective magnetic field applied for a time corresponding to a period of the spin procession shown in FIG. 4;

FIG. 7 is a graph illustrating a reaction of the electron of the magnetic layer of the magnetic recording medium shown in FIG. 2 with respect to an effective magnetic field applied for a time corresponding to half of the period of the spin procession shown in FIG. 4;

FIG. 8 schematically depicts parameters used in a model calculation of a multi-bit memory according to an exemplary embodiment of the present invention;

FIG. 9 is an example of a calculation showing a region where precessional switching is feasible and non-feasible (a cell writing window) in an exemplary method of the invention;

FIG. 10 depicts the precession period of the spin shown as a function of the aspect ratio for two different cell shapes, rectangular and ellipse according to the cell writing window calculated in Figure 9;

FIGs. 11A-11D graphically illustrate switching according to an exemplary method of the invention when fields Hx and/or Hy are applied;

FIG. 12 depicts four resistance states for four different magnetization configurations in Ms1 and Ms2, and its correlation to four different readback signal levels;

FIG. 13 illustrates a stage of forming a cell structure according to the invention prior to an etching process to create the bits; and

FIGs. 14A and 14B illustrate a stage of forming a cell structure according to the invention after an etching process to create the bits.

Hereinafter, a multi-bit MRAM according to an embodiment of the present invention, and methods of operating and sensing the multi-bit MRAM will be described in detail.

Aspects of the present invention, and methods for achieving them will be apparent to those skilled in the art from the detailed description of the exemplary embodiments together with the accompanying drawings. However, the scope of the present invention is not limited to the exemplary embodiments disclosed in the specification, and the present invention can be realized in various types. The described exemplary embodiments are presented only for completely disclosing the present invention and helping those skilled in the art to completely understand the scope of the present invention, and the present invention is defined only by the scope of the claims.

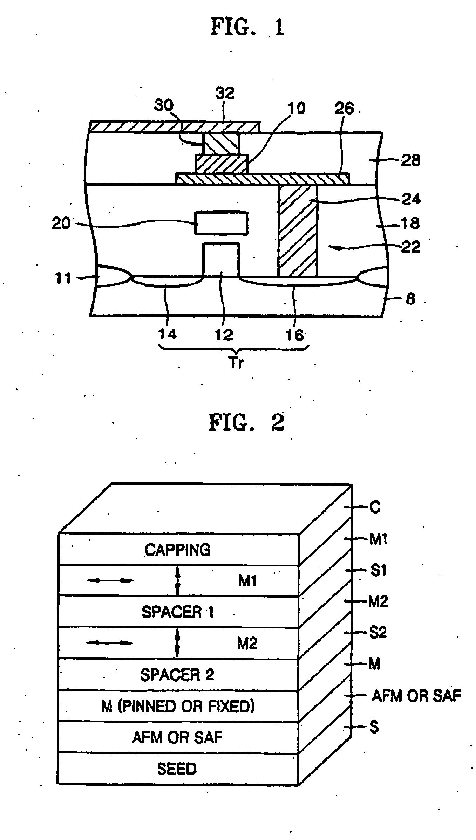

Referring to FIG. 1, a gate stack material 12 including a gate electrode is formed on a semiconductor substrate 8. Source and drain areas 14 and 16 are formed in the semiconductor substrate 8 beside both sides of the gate stack material 12. Thus, a transistor Tr is formed in the semiconductor substrate 8. Reference numeral 11 denotes a field oxide layer. An interlayer insulating layer 18 is formed on the semiconductor substrate 10 so as to cover the transistor Tr. A data line 20 is formed above the gate stack material 12 to be parallel with the gate stack material 12 and to be covered with the interlayer insulating layer 18 in a process of forming the interlayer insulating layer 18. A contact hole 22 is formed in the interlayer insulating layer 18 so as to expose the drain area 16. The contact hole 22 is filled with a conductive plug 24. A pad conductive layer 26 is formed on the interlayer insulating layer 18 so as to contact a front surface of the conductive plug 24. The pad conductive layer 26 is formed above the data line 20. A magnetic recording medium 10 on which 2-bit multi-bit data is to be recorded, for example, an MTJ layer, is formed in an area corresponding to the data line 20 of the pad conductive layer 26. The magnetic recording medium 10 will be described later. A second interlayer insulating layer 28 is formed on the resultant structure in which the magnetic recording medium 10 is formed, so as to cover the magnetic recording medium 10 and the pad conductive layer 26. A viahole 30 is formed in the second interlayer insulating layer 28 so as to expose an upper layer of the magnetic recording medium 10. A bit line 32 is formed on the second interlayer insulating layer 28 so as to fill the viahole 30. The bit line 32 is perpendicular to the gate electrode and the data line 20.

FIG. 2 schematically shows the MTJ cell 10 of the multi-bit MRAM shown in FIG. 1.

Referring to FIG. 2, the MTJ cell 10 which is a magnetic recording layer includes magnetic and non-magnetic multilayers. The bottom layer as shown is a seed layer S which can be magnetic or non-magnetic, or a combination thereof.

Magnetic layer M is fixed or pinned by means of exchange bias effect with an antiferromagnetic layer (AFM) or interlayer coupling via a synthetic antiferromagnetic layer (SAF).

A non-magnetic spacer layer S 1 is accommodated between magnetically changeable first and second ferromagnetic layers M1 and M2. S1 may be either a conductive or nonconductive layer. In the case for a conductive spacer layer, the memory device forms a Giant Magnetoresistance (GMR) structure. On the other hand, a non-conductive layer leads to a Magnetic Tunnel Junction (MTJ) structure.

The first and second ferromagnetic layers M1 and M2 are the data layers where information is stored. The first and second ferromagnetic layers M1 and M2 can be changed via an externally applied magnetic field and/or a spin-polarized electrical current (not shown).

The first and second ferromagnetic layers M1 and M2 may also have distinct magnetic and physical properties such as saturation magnetization, magnetic anisotropy, layer thickness, magnetostriction coefficient, coercivity, damping constant, and materials, among others.

Additionally, the first and second forromagnetic layers M1, M2 may include differing ferromagnetic materials, allowing for more efficient spin precession, as well as a same or differing thickness. In exemplary embodiments, the material may comprise an alloy of Ni, Fe, and Co, or a combination thereof.

Additionally, the magnetic layers M, M1 and M2 can have either in-plane or out-of-plane magnetization.

The magnetoresistance effect or change in electrical resistance with magnetization is achieved by changing the magnetization configuration in the first and second ferromagnetic layers M1 and M2.

The total change in resistance for current propagating through layers M/S2/M2 must be different from the total resistance change for current propagating through layers M2/S1/M1.

A top capping layer C may be included in the cell structure. The capping layer C has the function of protection against corrosion of the cell, and also may increase the Gilbert damping constant in the firs ferromagnetic layer M1.

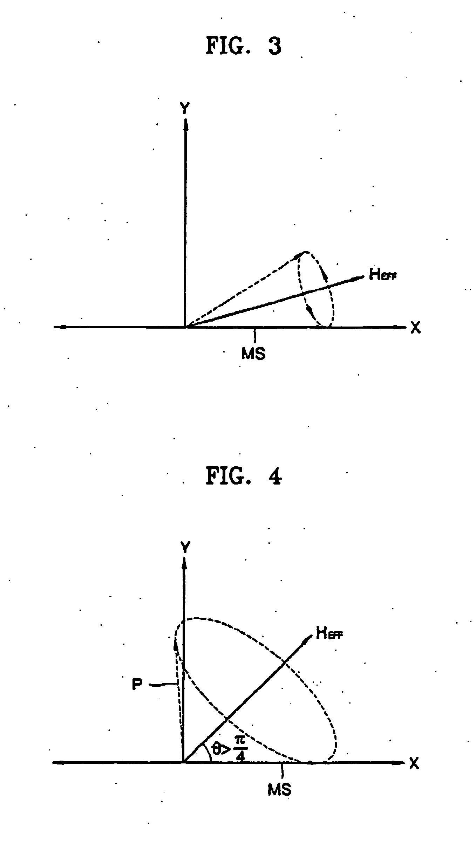

FIGS. 3 and 4 are views illustrating possible spin processions of electrons of first and second magnetic layers M1 and M2 when an effective magnetic field Heff is applied to the magnetic recording medium 10. Here, the effective magnetic field Heff or an external magnetic field is given a sum of vectors of a hard axis magnetic field Hy produced by a current supplied to the data line 20, an easy axis magnetic field Hx produced by a current supplied to a bit line 32, and a magnetic field repelling the applied magnetic fields Hy and Hx, i.e., an anisotropic magnetic field Hk.

Referring to FIG. 3, an angle between the effective magnetic field Heff and a magnetic polarization MS of electrons of the first and second magnetic layers M1 and M2, i.e., upper and lower magnetic layers, is smaller than an angle for reversing a direction of the magnetic polarization MS of the electrons, for example, $\pi/4$.

If the angle between the effective magnetic field Heff and the magnetic polarization MS of the electrons of the first and second magnetic layers M1 and M2 is smaller than the angle for reversing the direction of the magnetic polarization MS of the electrons as shown in FIG. 3, the electrons of the first and second magnetic layers M1 and M2 perform spin precessions based on the effective magnetic field Heff so as to be arranged along a direction of the effective magnetic field Heff. This means that the magnetic polarization MS of the first and second magnetic layers M1 and M2 is arranged along the direction of the effective magnetic field Heff.

However, the angle between the effective magnetic field Heff and the magnetic polarization MS of the electrons of the first and second magnetic layers M1 and M2 is smaller than $\pi/4$. Thus, a maximum angle at which the magnetic polarization MS of the electrons may become farther apart from an initial position during the spin procession of the electrons based on the effective magnetic field Heff is smaller than $\pi/2$. Thus, the magnetic polarization MS of the electrons fails to be reversed, and the effective magnetic field Heff disappears. As a result, the magnetic polarization MS of the electrons goes toward a direction for which the magnetic polarization MS of the electrons heads before the effective magnetic field Heff is applied, i.e., in direction +X. The magnetic polarization of the first and second magnetic layers M1 and M2 is a sum of vectors of magnetic polarizations of electrodes. Thus, if the angle between the effective magnetic field Heff and the magnetic polarization MS of the electrons is smaller than nl4, the magnetic polarization of the first and second magnetic layers 1 and M2 is excited but not reversed during the application of the effective magnetic field Heff. Also, the magnetic polarization of the first and second magnetic layers M1 and M2 returns to an original position immediately after the effective magnetic field Heff is removed.

If the angle between the effective magnetic field Heff and the magnetic polarization MS of the electrons is smaller than $\pi/4$ as described above, the state of the magnetic polarization of the first and second magnetic layers M1 and M2 is not changed. Thus, bit data recorded on the first and second magnetic layers M1 and M2 do not vary.

FIG. 4 is a view illustrating a spin procession of the electrons when the angle θ between the effective magnetic field Heff and the magnetic polarization MS of the electrons of the first and second magnetic layers M1 and M2 is greater than π/4.

Referring to FIG. 4, the angle θ between the effective magnetic field Heff and the magnetic polarization MS of the electrons of the first and second magnetic layers M1 and M2 is greater than π/4. Thus, a maximum angle at which the magnetic polarization MS of the electrons becomes farther apart from an initial position during the spin procession is greater than π/2. Vector components of the magnetic polarization MS of the electrons include -X and +Y direction components but not +X direction components in a position P in which the magnetic polarization MS of the electrons rotates from the initial position at an angle greater than π/2. Therefore, if the magnetic polarization MS of the electrons is in the position P and the effective magnetic field Heff is removed, the magnetic polarization MS of the electrons may be arranged in the direction -X. In other words, the magnetic polarization MS of the electrons is revered in an opposite direction to an initial direction. This result means that the direction of the magnetic polarization of the first and second magnetic layers M1 and M2 is reversed.

The spin precession of the electrons has a period. When a time for which an end of the magnetic polarization MS of the electrons rotates around the effective magnetic field Heff one time is referred to as a spin precession period T1, a time for which the magnetic polarization MS of the electrons reaches the position P is (1/2)T1. Thus, if the effective magnetic field Heff forms a greater angle than π/4 with the magnetic polarization MS of the electrons, the effective magnetic field Heff may be applied for times (1/2)T1, (3/2)T1, (5/2)T1... to reverse the direction of the magnetic polarization MS of the electrons.

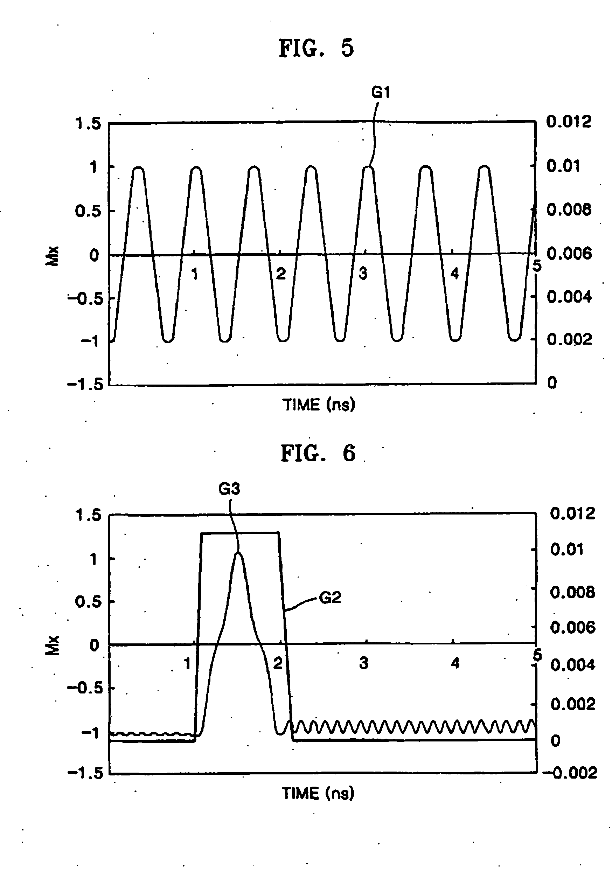

FIG. 5 is a view illustrating a graph G1 in which a spin precession of electrons in directions +X and -X under a predetermined effective magnetic field is expressed with a 2-dimensional periodic vibration.

FIG. 6 is a view 2-dimensionally expressing the spin precession of the electrons when effective magnetic field pulses are applied to the electrons having a periodic vibration as shown in FIG. 5 for a time corresponding to a period of the vibration. Reference character G2 denotes magnetic field pulses applied from an external source, and reference character G3 denotes spin excitation of an electron depending on the magnetic field pulses.

Referring to FIG. 6, when the effective magnetic field pulses G2 are applied for a time corresponding to a period of the vibration, the spin precession of the electrons is in a state in which the effective magnetic field pulses G2 are not yet applied. In other words, the spin arrangement of the electrons does not vary with the application of the effective magnetic field.

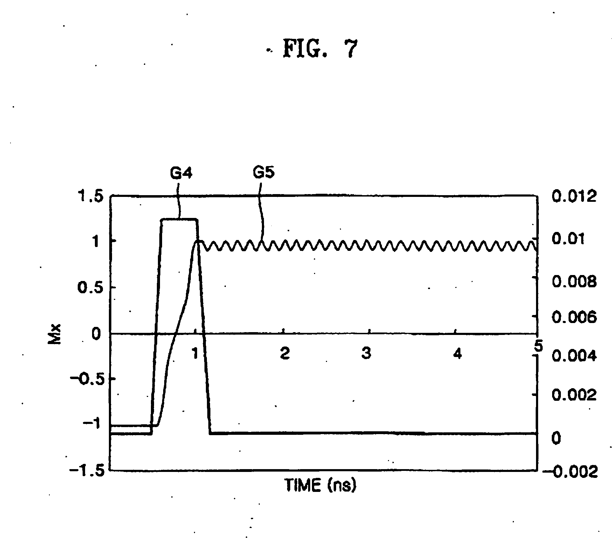

FIG. 7 shows a graph G5 illustrating variations in a spin excitation state of an electron reacting to effective magnetic field pulses G4 when the effective magnetic filed pulses G4 lasting for a time corresponding to half of a period of the vibration are applied to the electron having a periodic vibration as shown in FIG. 5.

Referring to FIG. 7, the spin excitation state of the electron is maximum during the application of the effective magnetic pulses G4. Also, the spin excitation state of the electron is maintained after the effective magnetic pulses G4 disappear. After the effective magnetic pulses G4 are applied, a direction of spin arrangement of the electron is changed into an opposite direction to a direction along which the spin of the electron is arranged before the effective magnetic pulses G4 are applied.

Memory cells according to the present invention described herein may have rounded ends to suppress magnetic domain nucleation, and an aspect ratio of each cell may be in a range of about 1.1 to 5.0.

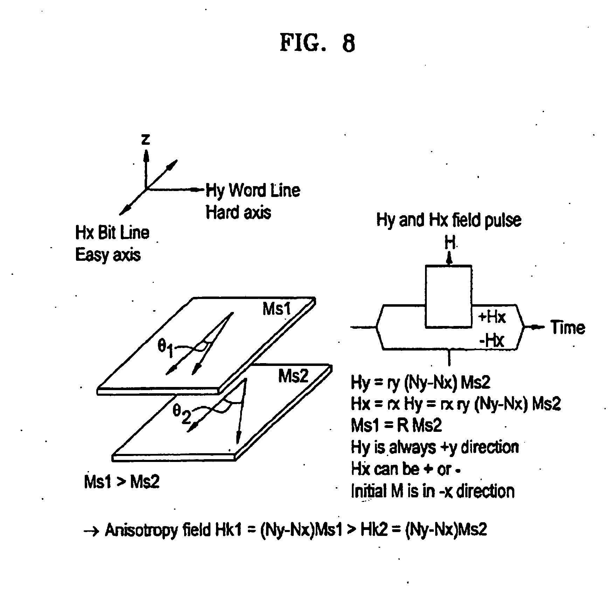

FIG. 8 schematically depicts parameters used in a model calculation of a multi-bit memory according to the present invention. During the write process, two electrical currents are applied, one along the Bit line Hx (the easy axis) and the other along the Word line Hy (the hard axis). Thus, two orthogonal magnetic fields are generated.

As shown in FIG. 8, Ms1 and Ms2 represent the saturation magnetization of the first and second ferromagnetic layer M1 and M2, respectively. The angles $\theta_1$ and $\theta_2$ are the magnetization angle of the first and second ferromagnetic layers M1 and M2 from the long axis (or easy axis) of a cell.

Shape anisotropy fields Hk1 and Hk2 of M1 and M2 are defined as (Ny-Nx) Ms1 and (Ny-Nx) Ms2 where Ny and Nx are the demagnetizing factor along the x and y-axis.

In the example of FIG. 8, two magnetic pulse fields are used in the model calculation. Hy is the hard axis magnetic field from the Word line applied along the positive direction only and Hx is the long axis magnetic field from the Bit line applied along the positive and negative x direction.

The pulse duration of Hx and Hy are different where Hx is longer than Hy. The ratio of Hy/Hk2, Hx/Hy and Ms1/Ms2 are represented by ry, rx and R in the calculation,
where:

$$Hy = ry\ (Ny\text{-}Nx)\ Ms2 \qquad\qquad (equation\ 1);$$

$$Hx = rx \, Hy = rx \, ry \, (Ny-Nx) \, Ms2 \qquad \text{(equation 2);}$$

and

$$Ms1 = R \, Ms2 \qquad \text{(equation 3).}$$

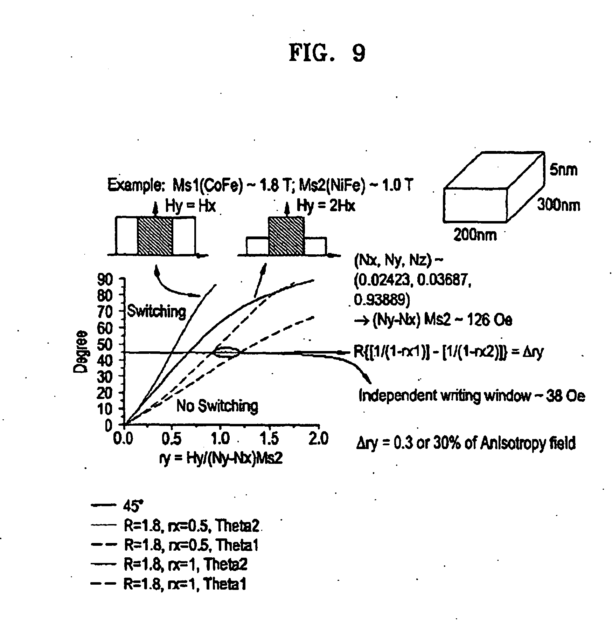

FIG. 9 is an example of a calculation showing a region where precessional switching is feasible and non-feasible (a cell writing window) in an exemplary method of the invention. In the exemplary embodiment of FIG. 9, CoFe and NiFe are used as the materials for the first and second ferromagnetic layers M1 and M2, respectively.

For this particular example, the memory cell has a rectangular shape with a dimension of 200nm x 300nm x 5nm as shown. The accompanying graph shows the angles of $\theta_1$ and $\theta_2$ in degrees as a function of ry for two values of rx, where rx =Hy/(Ny-Nx)Ms2.

As shown, the region where precessional switching is feasible and non-feasible is marked "Switching" and "No Switching". In this exemplary embodiment, the cell has a writing window of about 38 Oe or 30% of the shape anisotropy field (Ny-Nx) Ms2. In the embodiment, for an angle > 45°, switching is possible and no switching is possible for an angle < 45°

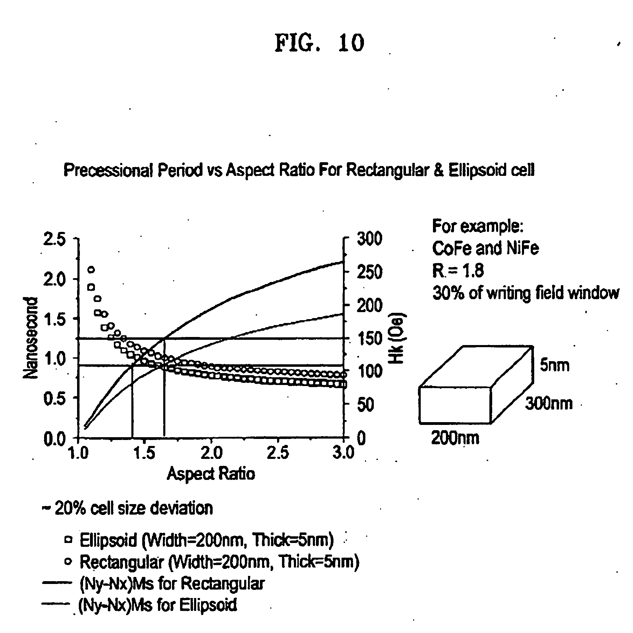

FIG. 10 depicts the precession period of the spin shown as a function of the aspect ratio for two different cell shapes, rectangular and ellipse according to the cell writing window calculated in FIG 9.

Using the 30% writing window depicted in FIG. 9, this translates into a cell size deviation tolerance of about 20% and a switching time in the order of 1 ns. Large cell size deviation tolerances increase the chance of independent addressing of the first and second ferromagnetic layers M1 and M2.

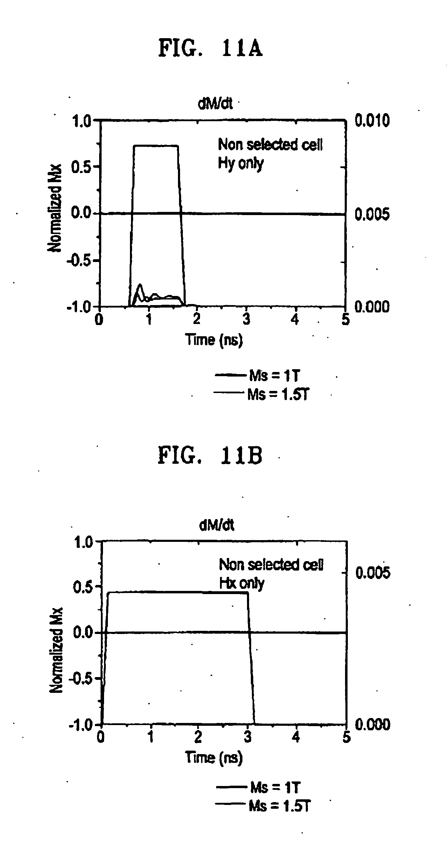

FIGs. 11A-11D graphically illustrate switching according to an exemplary method of the invention when fields Hx and/or Hy are applied.

In FIGs. 11A-11D, the evolution of the magnetization of Ms1 and Ms2 with time are found by solving the LLG equation.

Both magnetizations are initially along the -x direction. FIGs. 11A and 11B show the magnetization of the non-selected layer when exposed to only Hy or Hx. In this case, no switching occurs.

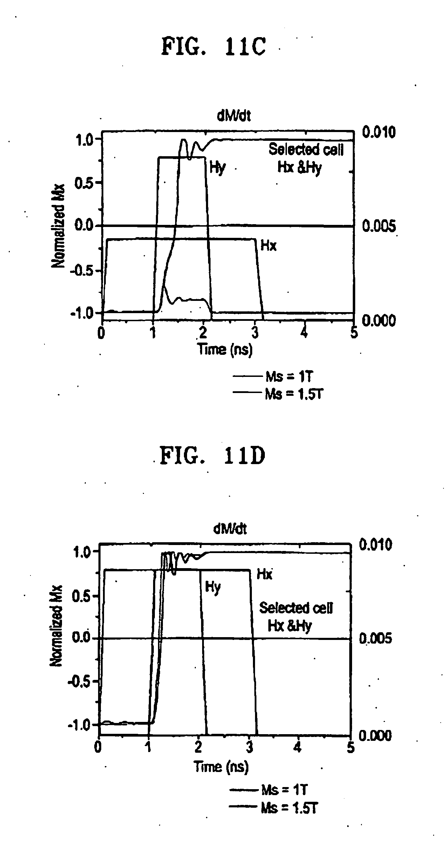

FIG. 11C shows the selected cell when Hx/Hy = 1/2. In this case, Ms2 has switched to a +x direction while Ms1 remains unchanged as the field pulses were terminated.

FIG. 11D shows the switching of both Ms1 and Ms2 in the selected cell by having Hx/Hy = 1.

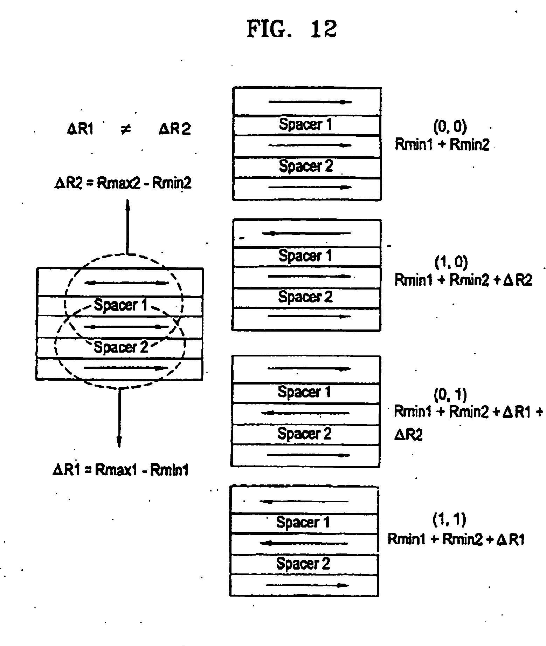

FIG. 12 depicts four resistance states for four different magnetization configurations in Ms1 and Ms2, and its correlation to four different readback signal levels.

As shown in FIG. 12, when the two magnetic layers are in parallel alignment, electrons experience less scattering and hence, lower electrical resistance compared to high resistance due to a high scattering rate when the layers are in an antiparallel configuration. Thus, one non-magnetic interface generates two signal levels, "1" and "0". The difference between high and low resistance states range from a few percent in GMR to nearly 100% in TMR. Therefore, a multilevel signal may be created by having more than one spacer with distinct material properties.

Multi-bit MRAM of the present invention may be created by growing magnetic multilayers with distinct, saturation magnetization free magnetic layers, where each free layer can store one binary bit information. The memory cell shape can be, for example, rectangular or elliptical. The layers may be formed by film-patterning, etching, and polishing techniques known in the art.

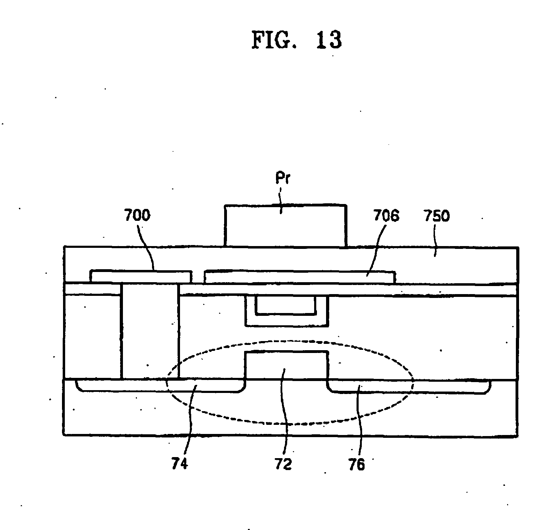

As shown in FIG. 13, during the manufacturing process, source area 74 is formed to the left of gate 72 while common drain area 76 is formed to the right of gate 72. These form the basic of a transistor structure. Magnetic multilayer 750 is formed to cover the first and second pads 700, 706. The magnetic multilayer 750 contains more than one free ferromagnetic layer. Also formed is pattern Pr above a predetermined area of multilayer 750.

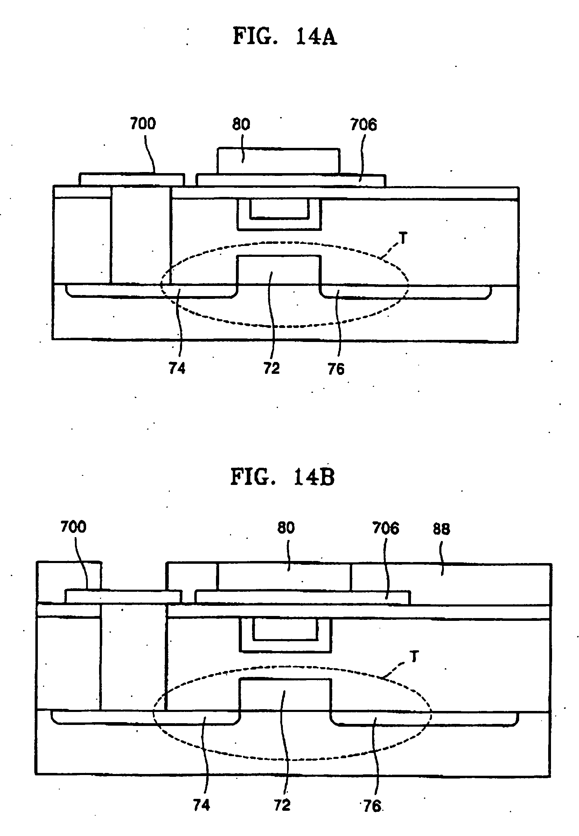

FIG. 14A shows the memory bits 80 that have been formed from layer 750 using Pr as the mask through multiple steps of chemical and/or plasma etching processes. The etching process is stopped once layer 706 is exposed. The remaining portions of pr must be removed through further chemical and/or plasma cleaning processes. Subsequently, as shown in FIG. 14B, layer 88 is formed to cover the memory bits 80 and first and second pads 700, 706. Layer 88 may be smoothed until the memory bits 80 are exposed. Methods for smoothing layer 88 may include, for example, etching and chemical/mechanical polishing. Layer 88 is non-conductive and its function is to isolate the top and bottom contact pad 706.

Therefore, two bits of information can be stored using one memory cell in the MRAM architecture. This structure reduces the number of bit and word lines used for the reading and writing processes. As a direct result, a higher magnetic memory density is achieved.

Storing two bits of information at one cross-point according to exemplary embodiments of the invention is possible since writing or changing the magnetization of the free layers of can be accomplished without affecting the information already stored in the other free layer.

The difference in saturation magnetization allows recording information in one bit without affecting the information in the other bit. This allows for selective writing.

In the writing method of the invention, the second applied magnetic field (the spin-precessional excitation field) may be turned-off as soon as the magnetization of the one free layer, for example, layer B, has precessed to more than 1/2 but less than 3/4 of the precession cycle. Subsequently, the first applied magnetic field (the easy axis field) is turned-off after the second applied magnetic field is turned-off. Likewise, the pulse of the easy axis field should have a longer duration than a pulse of the spin-precessional excitation field. In an exemplary embodiment, the pulse duration of the easy axis field is in a range of about 0.2 to 10 ns, while a pulse duration of the spin-precessional excitation field may be in a range of about 0.01 to 5 ns.

In addition, the first and second ferromagnetic layers M1 and M2 of the invention may have the same or differing spin precession frequencies. Also the first and second ferromagnetic layers M1 and M2 may have the same or differing magnetic damping constants to provide for better energy dissipation, as needed.

Using the aforementioned features, selective writing of the magnetically changeable ferromagnetic layers may be performed using a combination of a saturation magnetization ratio, magnetic isotropy ratio, easy to hard axis field magnitude ratio, and/or a spin polarized current density ratio. The ratio becomes important for making the magnetically changeable layers react differently to the applied field. When the magnetically changeable layers have the same properties, then it becomes difficult to write information in one layer without disturbing the remaining layers.

For example, take an embodiment with magnetically changeable layers 1 and 2. One of the most critical properties is the (saturation magnetization) x (layer thickness). This value represent the amount of energy required to write information in this selected layer. If Ms = Saturation magnetization, and t = layer thickness, then for layer 1, the energy required for writing is proportional to Ms1t1. Similarly the energy to write information in layer 2 is proportional to Ms2t2.

Now, in an exemplary embodiment, when Ms1t1 > Ms2t2, if the first writing field supplies an energy > Ms1t1, then both layer and 2 will be written. If Ms1t1 > writing field energy > Ms2t2, only layer 2 will be written. Therefore, the ratio of Ms1t1/Ms2t2 > 1 to 5. The larger the ratio, the bigger the difference in the energy required to write information in the layer. Thus, selective writing is performed.

A second method to distinguish the two layers is by using ferromagnetic material with distinct magnetic anisotropy constants, which is an intrinsic material property commonly represented by the symbol K. Suppose K1 and K2 are defined as the magnetic anisotropy of layer 1 and 2, respectively. In an exemplary embodiment, then the ratio of K1/K2 > 1 to 5.

The easy to hard axis field magnitude ratio depends on the shape of the memory cell. In an exemplary embodiment, the easy to hard axis field magnitude ratio is the same as the length/width ratio of the cell.

The spin-polarized current (SPC) is the amount of current required to write information in the layer. In exemplary embodiments, when using the spin-polarized current method, then there is no need to create a magnetic field. This is an alternative writing method. Further, the amount of current required depends on all the parameters mentioned above such as (Ms)x(t) and magnetic anisotropy constant (K). Therefore, in an exemplary embodiment, if layer 1 requires SPC1 and layer 2 requires SPC2, then SPC1/SPC2 > 1 to 5.

Accordingly, the present invention allows for improved data density by using a multi-bit MRAM structure, where a plurality of magnetically changeable ferromagnetic layers are used, each layer storing one bit.

Further, the present invention may use spin precessional switching which is energy efficient.

Finally, high frequency cell writing is possible, therefore leading to a higher data transfer rate.

Although exemplary embodiments of the present invention have been described for illustrative purposes, those skilled in the art will appreciate that various modifications, additions and substitutions are possible, without departing from the scope of the invention as disclosed in the accompanying claims.

**Claims**

1. A writing method for a magnetic memory including a switching device (Tr) and a magnetic recording medium (10) having upper (M1) and lower (M2) magnetic layers stacked on a pinned layer (M) having a fixed magnetization direction, a lower spacer (S2) formed between the pinned layer (M) and the lower magnetic layer (M2) and an upper spacer (S1) formed between the upper (M1) and lower (M2) magnetic layers;
   wherein a difference ΔR1 between maximum and minimum resistances of a stack of the pinned layer (M), the lower spacer (S2), and the lower magnetic layer (M2) is different from a difference ΔR2 between maximum and minimum resistances of a stack of the lower magnetic layer (M2), the upper spacer (S1), and the upper magnetic layer (M1); **characterised in that** bit data are written, wherein bit data are written to the magnetic recording medium by applying an external magnetic pulse including an easy axial direction magnetic pulse (Hx) and a perpendicular hard axial direction magnetic pulse (Hy);

wherein the intensity ratio of the easy axial direction magnetic pulse (Hx) to the hard axial direction magnetic pulse (Hy) is smaller than I and the hard axial direction magnetic pulse (Hy) is applied for a shorter duration than the easy axial direction magnetic pulse (Hx).

**2.** The writing method of claim 1, wherein the intensity of the easy axial direction magnetic pulse (Hx) is varied while the intensity of the hard axial direction magnetic pulse (Hy) is maintained constant.

**3.** The writing method of claim 1 or 2, wherein multi-bit data are selectively written to the magnetic recording medium by applying a first external magnetic pulse including an easy axial direction magnetic pulse (Hx) and an hard axial direction magnetic pulse (Hy) that have an equal intensity and applying a second external magnetic pulse including an hard axial direction magnetic pulse (Hy) and an easy axial direction magnetic pulse (Hx) that has a smaller intensity than the hard axial direction magnetic pulse (Hy) therein.

**4.** The writing method any of claims 1 to 3, wherein, assuming that a period of spin precession of electrons in the lower magnetic layer when the external magnetic pulse is applied is T1, the hard axial direction magnetic pulse (Hy) is applied for a duration of (n+1/2)T1 where n is an integer.

**5.** The writing method of any of claims 1 to 4, wherein, assuming that a period of spin precession of electrons in the upper magnetic layer when the external magnetic pulse is applied is T2, the hard axial direction magnetic pulse (Hy) is applied for a duration of nT2 where n is an integer.

**6.** A writing method according to any preceding claim wherein bit data are written to one of the upper and lower magnetic layers by applying spin polarization current to the magnetic recording medium.

**7.** A writing method according to any preceding claim comprising:

applying a first magnetic field by applying the easy axial direction magnetic pulse below a switching field along a long axis of the magnetic recording medium; and
applying a second magnetic field by applying the hard axial direction magnetic pulse orthogonal to the first magnetic field, wherein the first magnetic field is turned-off after the second magnetic field is turned-off.

**8.** The writing method for a magnetic memory according to claim 7, wherein a pulse of the first magnetic field has a longer duration than a pulse of the second magnetic field.

**9.** The writing method for a magnetic memory according to claim 7 or 8, wherein the upper and lower magnetic layers are independently written using a single writing event.

**10.** The writing method for a magnetic memory according to any of claims 7 to 9, wherein a pulse of the second magnetic field has a rise time which is equal to or less than 1 ns.

**11.** The writing method for a magnetic memory according to any of claims 7 to 10, wherein the upper magnetic layer (M1) has a damping constant greater than the damping constant of the lower magnetic layer (M2) such that a writing response time of the upper magnetic layer is delayed to accomplish independent writing.

**12.** The writing method for a magnetic memory according to any of claims 7 to 11, wherein the pulse of the magnetic fields are shaped to generate a fast rising field to create a rise time that activates spin precession.

**13.** The writing method for a magnetic memory according to any of claims 7 to 12, wherein the pulse of the magnetic fields are shaped in one of a trapezoidal or exponential shape.

**14.** The writing method for a magnetic memory according to any of claims 7 to 13, further comprising sensing stored information in each of the upper and lower magnetic layers (M1, M2) using a magnetoresistance effect.

15. The writing method for a magnetic memory according to any of claims 7 to 14, further comprising terminating the second magnetic field when the magnetization of the upper magnetic layer (M1) has been through (n + 1/2) precession cycles, where n is a number of precession cycles.

16. The writing method according to any of claims 1 to 15, wherein a pulse duration of the first magnetic field is in a range of 0.2 to 10 ns, while a pulse duration of the second magnetic field is in a range of 0.01 to 5 ns.

17. The writing method according to any of claims I to 16, further comprising controlling at least one of a saturation magnetization and magnetic anisotropy ratio of the upper and lower magnetic layers (M1, M2) to achieve independent writing.

18. The writing method according to any of claims 1 to 17, wherein the upper and lower magnetic layers (M1, M2) and the upper spacer (S1) as a structure have a differing MR ratio than a structure including the lower magnetic layer (M2), the lower spacer (S2), and the reference layer (M).

19. The writing method according to any of claims 1 to 18, wherein the upper and lower magnetic layers (M1, M2) are written as (1,1) and (0,0) using a single writing event, and (1,0) and (0,1) using two writing events.

20. The writing method according to any of claims 1 to 19, wherein the upper and lower magnetic layers (M1, M2) are written as (1,0) by first writing "1" in both of the upper and lower magnetic layers, followed by a second writing event to write "0" in the magnetically softer magnetic layer (M1, M2).

21. The writing method according to any of claims 1 to 20, wherein the upper and lower magnetic layers (M1, M2) are written as (0,1) by first writing "0" in both the upper and lower magnetic layers, followed by a second writing event to write "1" in the magnetically softer magnetic layer (M 1, M2).

22. The writing method according to any of claims 1 to 21, further comprising inducing orthogonal unidirectional anisotropy in one of the upper and lower magnetic layers (M1, M2).

23. The writing method according to any of claims 1 to 22, further comprising setting a magnetization pinning axis of the reference layer (M) orthogonal to the long axis of the memory cell.

24. A magnetic random access memory comprising:

   a switching device (Tr);
   a magnetic recording medium (10) connected to the switching device (Tr);
   a first magnetic field generating unit (20) installed between the switching device (Tr) and the magnetic recording medium (10); and
   a second magnetic field generating unit (32) connected to the magnetic recording medium (10),

   wherein the magnetic recording medium (10) comprises:

   upper (M1) and lower (M2) magnetic layers that are magnetically changeable and are sequentially stacked on a pinned layer (M) having a fixed magnetization direction;

   **characterised in that** the magnetic random access memory is arranged to write data using a method according to any of claims 1 to 23.

25. The magnetic memory according to claim 24, further comprising a third magnetic layer on the upper magnetic layer, wherein the upper and third magnetic layers are separated from one another by a third spacer layer.

26. The magnetic memory according to claim 24 or 25, wherein the upper and lower magnetic layers (M1, M2) have a differing ferromagnetic material.

27. The magnetic memory according to any of claims 24 to 26, wherein the upper and lower magnetic layers have a differing thickness.

28. The magnetic memory according to any of claims 24 to 27, wherein the upper and lower magnetic layers (M1, M2) have a differing magnetocrystalline anisotropy.

29. The magnetic memory according to any of claims 24 to 28, wherein the upper and lower magnetic layers (M1, M2) comprise one of an in-plane magnetocrystalline anisotropy, an out-of-plane magnetocrystalline anisotropy, and a combination of an in-plane magnetocrystalline anisotropy and an out-of-plane magnetocrystalline anisotropy.

30. The magnetic memory according to any of claims 24 to 29, wherein the upper and lower magnetic layers (M1, M2) comprise an alloy ofNi, Fe and Co, or a combination thereof.

31. The magnetic memory according to any of claims 24 to 30, wherein each of the upper and lower magnetic layers (M1, M2) is arranged to store one bit of binary information.

32. The magnetic memory according to any of claims 24 to 31, wherein the upper and lower magnetic layers (M1, M2) have differing spin precession frequencies.

33. The magnetic memory according to any of claims 24 to 32, wherein a cell formed by the magnetic (M1, M2) and spacer layers (S1, S2) includes rounded ends for suppressing magnetic domain nucleation.

34. The magnetic memory according to any of claims 24 to 33, wherein a cell formed by the magnetic and spacer layers (M1, M2, S1, S2) has as aspect ratio in a range of about 1.1 and 5.0.

35. The magnetic memory of any of claims 24 to 34, wherein the upper and lower magnetic layers (M1, M2) have different saturated magnetizations.

36. The magnetic memory of any of claims 24 to 35, wherein the upper and lower magnetic layers (M1, M2) are identical magnetic material layers, wherein a capping layer (C) increasing the Gilbert's decay constant is formed on the upper magnetic layer.

37. The magnetic memory of any of claims 24 to 36, further comprising a capping layer (C) on the upper magnetic layer (M1).

38. The magnetic memory of any of claims 24 to 37, wherein the upper and lower spacers (S1, S2) have different thicknesses.

39. The magnetic memory of any of claims 24 to 38 , wherein the upper and lower spacers (S1, S2) are formed of different materials.

40. The magnetic memory of any of claims 24 to 39, wherein the upper and lower spacers (S1, S2) have different saturated magnetizations.

41. The magnetic memory of any of claims 24 to 40, wherein the upper and lower magnetic layers (M1, M2) have different saturated magnetizations.

42. The magnetic memory of claim 25 wherein the third spacer is formed of a conductive material, a non-conductive material, or a mixture of the forgoing materials.

43. The magnetic memory of claim 25 or 42, wherein the upper magnetic layer, the lower magnetic layer, and the third magnetic layer have different saturated magnetizations.

44. The magnetic memory of claim 25, 42 or 43, further comprising a capping layer increasing the Gilbert's decay constant on the third magnetic layer.

45. The magnetic memory of any of claims 24 to 44, wherein the first magnetic field generating unit is a data line, and the second magnetic field generating unit is a bit line.

46. The magnetic memory of any of claims 24 to 45, wherein the upper and lower magnetic layers are magnetic material layers causing vertical magnetization.

**47.** The magnetic memory of claim 25, 42, 43 or 44, wherein the upper magnetic layer, the lower magnetic layer, and the third magnetic layer are magnetic material layers causing vertical magnetization.

**48.** The magnetic memory of any of claims 24 to 47, further comprising a filter generating spin polarization current in or on the magnetic recording medium.

**Patentansprüche**

**1.** Schreibverfahren für einen Magnetspeicher mit einer Schaltvorrichtung (Tr) und einem Magnetaufzeichnungsmedium (10), das eine obere (M1) und eine untere (M2) Magnetschicht, die auf einer gepinnten Schicht (M) mit einer festgelegten Magnetisierungsrichtung aufgestapelt sind, einen unteren Abstandhalter (S2), der zwischen der gepinnten Schicht (M) und der unteren Magnetschicht (M2) ausgebildet ist, und einen oberen Abstandhalter (S1) aufweist, der zwischen der oberen (M1) und der unteren Magnetschicht (M2) ausgebildet ist,
wobei eine Differenz ΔR1 zwischen maximalem und minimalem Widerstand eines Stapels der gepinnten Schicht (M), des unteren Abstandhalters (S2) und der unteren Magnetschicht (M2) sich von einer Differenz ΔR2 zwischen maximalem und minimalem Widerstand eines Stapels der unteren Magnetschicht (M2), des oberen Abstandhalters (S1) und der oberen Magnetschicht (M1) unterscheidet,
**dadurch gekennzeichnet, dass** Bitdaten eingeschrieben werden, wobei die Bitdaten in das Magnetaufzeichnungsmedium **dadurch** eingeschrieben werden, dass ein externer Magnetpuls mit einem Magnetpuls (Hx) in Richtung der weichen Achse und einem senkrechten Magnetpuls (Hy) in richtung der harten Achse angelegt wird,
wobei das Intensitätsverhältnis des Magnetpulses (Hx) in Richtung der weichen Achse zum Magnetpuls (Hy) in Richtung der harten Achse kleiner als 1 ist und der Magnetpuls (Hy) in Richtung der harten Achse für eine kürzere Dauer angelegt wird als der Magnetpuls (Hx) in Richtung der weichen Achse.

**2.** Schreibverfahren nach Anspruch 1, wobei die Intensität des Magnetpulses (Hx) in Richtung der weichen Achse veränderlich ist, während die Intensität des Magnetpulses (Hy) in Richtung der harten Achse konstant gehalten wird.

**3.** Schreibverfahren nach Anspruch 1 oder 2, wobei Multibitdaten in das Magnetaufzeichnungsmedium **dadurch** selektiv eingeschrieben werden, dass ein erster externer Magnetpuls angelegt wird, der einen Magnetpuls (Hx) in Richtung der weichen Achse und einen Magnetpuls (Hy) in Richtung der harten Achse beinhaltet, die eine gleiche Intensität aufweisen, und ein zweiter externer Magnetpuls angelegt wird, der einen Magnetpuls (Hy) der harten Achse und einen Magnetpuls (Hx) in Richtung der weichen Achse beinhaltet, der dabei eine geringere Intensität als der Magnetpuls (Hy) in Richtung der harten Achse aufweist.

**4.** Schreibverfahren nach einem der Ansprüche 1 bis 3, wobei unter der Annahme, dass eine Periode einer Spinpräzession von Elektronen in der unteren Magnetschicht, wenn der externe Magnetpuls angelegt wird, T1 beträgt, der Magnetpuls (Hy) in Richtung der harten Achse für eine Dauer von (n + 1/2)T1 angelegt wird, wobei n eine ganze Zahl ist.

**5.** Schreibverfahren nach einem der Ansprüche 1 bis 4, wobei unter der Annahme, dass eine Periode einer Spinpräzession von Elektronen in der oberen Magnetschicht, wenn der externe Magnetpuls angelegt wird, T2 beträgt, der Magnetpuls (Hy) in Richtung der harten Achse für eine Dauer von nT2 angelegt wird, wobei n eine ganze Zahl ist.

**6.** Schreibverfahren nach einem der vorhergehenden Ansprüche, wobei Bitdaten in die obere oder untere Magnetschicht durch Anlegen eines Spinpolarisationsstroms an das Magnetaufzeichnungsmedium eingeschrieben werden.

**7.** Schreibverfahren nach einem der vorhergehenden Ansprüche umfassend:

Anlegen eines ersten Magnetfelds durch Anlegen des Magnetpulses in Richtung der weichen Achse unter einem Umschaltfeld entlang einer langen Achse des Magnetaufzeichnungsmediums und
Anlegen eines zweiten Magnetfelds durch Anlegen des Magnetpulses in Richtung der harten Achse orthogonal zum ersten Magnetfeld, wobei das erste Magnetfeld abgeschaltet wird, nachdem das zweite Magnetfeld abgeschaltet ist.

**8.** Schreibverfahren für einen Magnetspeicher nach Anspruch 7, wobei ein Puls des ersten Magnetfelds eine längere Dauer aufweist als ein Puls des zweiten Magnetfelds.

9. Schreibverfahren für einen Magnetspeicher nach Anspruch 7 oder 8, wobei die obere und untere Magnetschicht unter Verwendung eines einzigen Schreibvorgangs unabhängig beschrieben werden.

10. Schreibverfahren für einen Magnetspeicher nach einem der Ansprüche 7 bis 9, wobei ein Puls des zweiten Magnetfelds eine Anstiegszeit aufweist, die gleich oder kleiner 1 ns ist.

11. Schreibverfahren für einen Magnetspeicher nach einem der Ansprüche 7 bis 10, wobei die obere Magnetschicht (M1) eine Dämpfungskonstante aufweist, die höher ist als die Dämpfungskonstante der unteren Magnetschicht (M2), so dass eine Schreibansprechzeit der oberen Magnetschicht verzögert ist, so dass unabhängiges Einschreiben erreicht wird.

12. Schreibverfahren für einen Magnetspeicher nach einem der Ansprüche 7 bis 11, wobei der Puls der Magnetfelder so gestaltet wird, dass ein schnell ansteigendes Feld erzeugt wird, um eine Anstiegszeit zu erreichen, die eine Spinpräzession aktiviert.

13. Schreibverfahren für einen Magnetspeicher nach einem der Ansprüche 7 bis 12, wobei der Puls der Magnetfelder in eine Trapezform oder exponentielle Form gestaltet wird.

14. Schreibverfahren für einen Magnetspeicher nach einem der Ansprüche 7 bis 13, ferner umfassend Abtasten gespeicherter Information in jeder der oberen und unteren Magnetschichten (M1, M2) unter Verwendung eines Magnetowiderstandseffekts.

15. Schreibverfahren für einen Magnetspeicher nach einem der Ansprüche 7 bis 14, ferner umfassend Beenden des zweiten Magnetfelds, wenn die Magnetisierung der oberen Magnetschicht (M1) (n + 1/2) Präzessionszyklen durchlaufen hat, wobei n eine Anzahl an Präzessionszyklen ist.

16. Schreibverfahren nach einem der Ansprüche 1 bis 15, wobei eine Pulsdauer des ersten Magnetfelds im Bereich von 0,2 bis 10 ns liegt, während eine Pulsdauer des zweiten Magnetfelds in einem Bereich von 0,01 bis 5 ns liegt.

17. Schreibverfahren nach einem der Ansprüche 1 bis 16, ferner umfassend Steuern einer Sättigungsmagnetisierung und/oder eines magnetischen Anisotropieverhältnisses der oberen und unteren Magnetschichten (M1, M2), um unabhängiges Einschreiben zu erreichen.

18. Schreibverfahren nach einem der Ansprüche 1 bis 17, wobei die obere und untere Magnetschicht (M1, M2) und der obere Abstandhalter (S1) eine Struktur aufweisen, die ein anderes MR-Verhältnis besitzt als eine Struktur mit einer unteren Magnetschicht (M2), dem unteren Abstandhalter (S2) und der Referenzschicht (M).

19. Schreibverfahren nach einem der Ansprüche 1 bis 18, wobei die obere und untere Magnetschicht (M1, M2) als (1, 1) und (0, 0) unter Verwendung eines einzigen Schreibvorgangs und als (1, 0) und (0, 1), unter Verwendung zweier Schreibvorgänge beschrieben werden.

20. Schreibverfahren nach einem der Ansprüche 1 bis 19, wobei die obere und untere Magnetschicht (M1, M2) als (1, 0) beschrieben werden, indem zuerst "1" sowohl in die obere wie die untere Magnetschicht eingeschrieben wird, gefolgt von einem zweiten Schreibvorgang, bei dem "0" in die magnetisch weichere Magnetschicht (M1, M2) eingeschrieben wird.

21. Schreibverfahren nach einem der Ansprüche 1 bis 20, wobei die obere und untere Magnetschicht (M1, M2) als (0, 1) beschrieben werden, indem zuerst "0" sowohl in die obere wie die untere Magnetschicht eingeschrieben wird, gefolgt von einem zweiten Schreibvorgang, bei dem "1" in die magnetisch weichere Magnetschicht (M1, M2) eingeschrieben wird.

22. Schreibverfahren nach einem der Ansprüche 1 bis 21, ferner umfassend Induzieren einer orthogonalen unidirektionalen Anisotropie in der oberen oder unteren Magnetschicht (M1, M2).

23. Schreibverfahren nach einem der Ansprüche 1 bis 22, ferner umfassend Festlegen einer Magnetisierungsspinningachse der Referenzschicht (M) orthogonal zur langen Achse der Speicherzelle.

24. Magnetischer Direktzugriffspeicher umfassend:

eine Schaltvorrichtung (Tr),

ein Magnetaufzeichnungsmedium (10), das mit der Schaltvorrichtung (Tr) verbunden ist,

eine erste Magnetfelderzeugungseinheit (20), die zwischen der Schaltvorrichtung (Tr) und dem Magnetaufzeichnungsmedium (10) installiert ist, und

eine zweite Magnetfelderzeugungseinheit (32), die mit dem Magnetaufzeichnungsmedium (10) verbunden ist,

wobei das Magnetaufzeichnungsmedium (10) umfasst:

eine obere (M1) und eine untere (M2) Magnetschicht, die magnetisch veränderlich sind und sequentiell auf einer gepinnten Schicht (M) mit einer festgelegten Magnetisierungsrichtung aufgestapelt sind,

**dadurch gekennzeichnet, dass** der magnetische Direktzugriffspeicher so ausgebildet ist, dass er Daten unter Verwendung eines Verfahrens nach einem der Ansprüche 1 bis 23 einschreibt.

25. Magnetspeicher nach Anspruch 24, ferner umfassend eine dritte Magnetschicht auf der oberen Magnetschicht, wobei die obere und dritte Magnetschicht voneinander durch eine dritte Abstandhalterschicht getrennt sind.

26. Magnetspeicher nach Anspruch 24 oder 25, wobei die obere und untere Magnetschicht (M 1, M2) ein unterschiedliches ferromagnetisches Material aufweisen.

27. Magnetspeicher nach einem der Ansprüche 24 bis 26, wobei die obere und untere Magnetschicht eine unterschiedliche Dicke aufweisen.

28. Magnetspeicher nach einem der Ansprüche 24 bis 27, wobei die obere und untere Magnetschicht (M1, M2) eine unterschiedliche magnetokristalline Anisotropie aufweisen.

29. Magnetspeicher nach einem der Ansprüche 24 bis 28, wobei die obere und untere Magnetschicht (M1, M2) eine magnetokristalline Anisotropie in der Ebene, eine magnetokristalline Anisotropie außerhalb der Ebene oder eine Kombination von magnetokristalliner Anisotropie in der Ebene und magnetokristalliner Anisotropie außerhalb der Ebene aufweisen.

30. Magnetspeicher nach einem der Ansprüche 24 bis 29, wobei die obere und untere Magnetschicht (M1, M2) eine Legierung von Ni, Fe und Co oder eine Kombination davon umfassen.

31. Magnetspeicher nach einem der Ansprüche 24 bis 30, wobei jede der oberen und unteren Magnetschicht (M 1, M2) so ausgebildet ist, dass sie ein Bit binärer Information speichert.

32. Magnetspeicher nach einem der Ansprüche 24 bis 31, wobei die obere und untere Magnetschicht (M1, M2) unterschiedliche Spinpräzessionsfrequenzen aufweisen.

33. Magnetspeicher nach einem der Ansprüche 24 bis 32, wobei eine durch die Magnet- (M1, M2) und Abstandhalterschichten (S1, S2) gebildete Zelle abgerundete Enden aufweist, so dass Magnetdomänennukleation unterdrückt wird.

34. Magnetspeicher nach einem der Ansprüche 24 bis 33, wobei eine durch die Magnet- und Abstandhalterschichten (M1, M2, S1, S2) gebildete Zelle ein Aspektverhältnis in einem Bereich von ungefähr 1,1 bis 5,0 aufweist.

35. Magnetspeicher nach einem der Ansprüche 24 bis 34, wobei die obere und untere Magnetschicht (M1, M2) unterschiedliche Sättigungsmagnetisierungen aufweisen.

36. Magnetspeicher nach einem der Ansprüche 24 bis 35, wobei die obere und untere Magnetschicht (M1, M2) Schichten mit identischem Magnetmaterial sind, wobei eine Abdeckschicht (C), die die Gilbert-Zerfallskonstante erhöht, auf der oberen Magnetschicht ausgebildet ist.

37. Magnetspeicher nach einem der Ansprüche 24 bis 36, ferner umfassend eine Abdeckschicht (C) auf der oberen Magnetschicht (M1).

38. Magnetspeicher nach einem der Ansprüche 24 bis 37, wobei der obere und untere Abstandhalter (S1, S2) unterschiedliche Dicken aufweisen.

39. Magnetspeicher nach einem der Ansprüche 24 bis 38, wobei der obere und untere Abstandhalter (S1, S2) aus unterschiedlichen Materialien gebildet sind.

40. Magnetspeicher nach einem der Ansprüche 24 bis 39, wobei der obere und untere Abstandhalter (S1, S2) unterschiedliche Sättigungsmagnetisierungen aufweisen.

41. Magnetspeicher nach einem der Ansprüche 24 bis 40, wobei die obere und untere Magnetschicht (M1, M2) unterschiedliche Sättigungsmagnetisierungen aufweisen.

42. Magnetspeicher nach Anspruch 25, wobei der dritte Abstandhalter aus einem leitfähigen Material, einem nicht leitfähigen Material oder einer Mischung der vorstehend genannten Materialien gebildet ist.

43. Magnetspeicher nach Anspruch 25 oder 42, wobei die obere Magnetschicht, die untere Magnetschicht und die dritte Magnetschicht unterschiedliche Sättigungsmagnetisierungen aufweisen.

44. Magnetspeicher nach Anspruch 25, 42 oder 43, ferner umfassend eine Abdeckschicht, die die Gilbert-Zerfallskonstante erhöht, auf der dritten Magnetschicht.

45. Magnetspeicher nach einem der Ansprüche 24 bis 44, wobei die erste Magnetfelderzeugungseinheit eine Datenleitung ist und die zweite Magnetfelderzeugungseinheit eine Bitleitung ist.

46. Magnetspeicher nach einem der Ansprüche 24 bis 45, wobei die obere und untere Magnetschicht Magnetmaterialschichten sind, die vertikale Magnetisierung bewirken.

47. Magnetspeicher nach Anspruch 25, 42, 43 oder 44, wobei die obere Magnetschicht, die untere Magnetschicht und die dritte Magnetschicht Magnetmaterialschichten sind, die vertikale Magnetisierung bewirken.

48. Magnetspeicher nach einem der Ansprüche 24 bis 47, ferner umfassend einen Filter, der einen Spinpolarisationsstrom in oder auf dem Magnetaufzeichnungsmedium erzeugt.

## Revendications

1. Procédé d'écriture pour une mémoire magnétique comprenant un dispositif de commutation (Tr) et un support d'enregistrement magnétique (10) ayant des couches magnétiques supérieure (M1) et inférieure (M2) empilées sur une couche piégée (M) ayant une direction de magnétisation fixe, un séparateur inférieur (S2) réalisé entre la couche piégée (M) et la couche magnétique inférieure (M2) ; et un séparateur supérieur (S1) réalisé entre les couches magnétiques supérieure (M1) et inférieure (M2) ;
dans lequel la différence $\Delta R1$ entre les résistances maximum et minimum de la pile constituée de la couche piégée (M), du séparateur inférieur (S2), et de la couche magnétique inférieure (M2) est différente de la différence $\Delta R2$ entre les résistances maximum et minimum de la pile constituée de la couche magnétique inférieure (M2), du séparateur supérieur (S1) et de la couche magnétique supérieure (M1) ;
**caractérisé par le fait que** des données de bit sont écrites, dans lequel les données de bit sont écrites sur le support d'enregistrement magnétique en appliquant une impulsion magnétique externe comprenant une impulsion magnétique de direction axiale facile (Hx) et une impulsion de direction axiale difficile perpendiculaire (Hy) ;
dans lequel le rapport d'intensité entre l'impulsion magnétique de direction axiale facile (Hx) et l'impulsion magnétique de direction axiale difficile (Hy) est plus petit que 1, et l'impulsion magnétique de direction axiale difficile (Hy) est appliquée pendant une durée plus courte que l'impulsion magnétique de direction axiale facile (Hx).

2. Procédé d'écriture selon la revendication 1, dans lequel intensité de l'impulsion magnétique de direction axiale facile (Hx) varie tandis que l'intensité de l'impulsion de direction axiale difficile (Hy) est maintenue constante.

3. Procédé d'écriture selon l'une des revendications 1 ou 2, dans lequel des données multi bit sont écrites de façon sélective sur le support d'enregistrement magnétique en appliquant une première impulsion magnétique externe comprenant une impulsion magnétique de direction axiale facile (Hx) et une impulsion magnétique de direction axiale difficile (Hy) qui ont une intensité égale, et en appliquant une seconde impulsion magnétique externe comprenant une impulsion magnétique de direction axiale difficile (Hy) et une impulsion magnétique de direction axiale facile (Hx) qui a une plus petite intensité que l'impulsion magnétique de direction axiale difficile (Hy) à l'intérieur.

4. Procédé d'écriture selon l'une quelconque des revendications 1 à 3, dans lequel, en supposant que la période de précession de spin des électrons dans la couche magnétique inférieure, quand l'impulsion magnétique externe est appliquée, est T1, l'impulsion magnétique de direction axiale facile (Hy) est appliquée pendant une durée de (n+1/2) T1, où n est un entier.

5. Procédé d'écriture selon l'une quelconque des revendications 1 à 4, dans lequel, en supposant que la période de précession de spin des électrons dans la couche magnétique supérieure, quand l'impulsion magnétique externe est appliquée, est T2, l'impulsion magnétique de direction axiale difficile (Hy) est appliquée pendant une durée de nT2, où n est un entier.

6. Procédé d'écriture selon l'une quelconque des revendications précédentes, dans lequel les données binaires sont écrites sur l'une des couches magnétiques supérieure et inférieure en appliquant un courant de polarisation de spin au support d'enregistrement magnétique.

7. Procédé d'écriture selon l'une quelconque des revendications précédentes, comprenant :

   l'application d'un premier champ magnétique en appliquant l'impulsion magnétique de direction axiale facile en dessous du champ de commutation le long du grand axe du support d'enregistrement magnétique ; et
   l'application d'un second champ magnétique en appliquant l'impulsion magnétique de direction axiale difficile orthogonalement au premier champ magnétique,

   dans lequel le premier champ magnétique est coupé après que le second champ magnétique a été coupé.

8. Procédé d'écriture pour une mémoire magnétique selon la revendication 7, dans lequel l'impulsion du premier champ magnétique a une durée plus longue que l'impulsion du second champ magnétique.

9. Procédé d'écriture pour une mémoire magnétique selon l'une des revendications 7 ou 8, dans lequel les couches magnétiques supérieure et inférieure sont écrites indépendamment en utilisant un unique événement d'écriture.

10. Procédé d'écriture pour une mémoire magnétique selon l'une quelconque des revendications 7 à 9, dans lequel l'impulsion du second champ magnétique a un temps de montée qui est égal ou inférieur à 1 ns.

11. Procédé d'écriture pour une mémoire magnétique selon l'une quelconque des revendications 7 à 10, dans lequel la couche magnétique supérieure (M1) a une constante d'amortissement supérieure à la constante d'amortissement de la couche magnétique inférieure (M2), de façon à ce que le temps de réponse d'écriture de la couche magnétique supérieure soit retardé pour réaliser une écriture indépendante.

12. Procédé d'écriture pour une mémoire magnétique selon l'une quelconque des revendications 7 à 11, dans lequel les impulsions des champs magnétiques ont la forme appropriée pour générer un champ montant rapide pour créer un temps de montée qui active la précession de spin.

13. Procédé d'écriture pour une mémoire magnétique selon l'une quelconque des revendications 7 à 12, dans lequel les impulsions des champs magnétiques ont une forme qui est une des formes trapézoïdale ou exponentielle.

14. Procédé d'écriture pour une mémoire magnétique selon l'une quelconque des revendications 7 à 13, comprenant en outre l'acquisition d'informations stockées dans chacune des couches magnétiques supérieure et inférieure (M1, M2) en utilisant un effet de magnéto résistance.

15. Procédé d'écriture pour une mémoire magnétique selon l'une quelconque des revendications 7 à 14, comprenant en outre l'arrêt du second champ magnétique quand la magnétisation de la couche magnétique supérieure (M1) est passée par (n+1/2) cycles de précession, où n est un nombre de cycles de précession.

16. Procédé d'écriture selon l'une quelconque des revendications 1 à 15, dans lequel la durée d'une impulsion du premier champ magnétique est dans la plage de 0,2 à 10 ns, tandis que la durée d'une impulsion du second champ magnétique est dans la plage de 0,01 à 5 ns.

**17.** Procédé d'écriture selon l'une quelconque des revendications 1 à 16, comprenant en outre le contrôle d'au moins un élément parmi la magnétisation de saturation et le taux d'anisotropie magnétique des couches magnétiques supérieure et inférieure (M1, M2) pour réaliser une écriture indépendante.

**18.** Procédé d'écriture selon l'une quelconque des revendications 1 à 17, dans lequel les couches magnétiques supérieure et inférieure (M1, M2) et le séparateur supérieur (S1) pris comme structure ont un rapport MR différent de celui de la structure comprenant la couche magnétique inférieure (M2), le séparateur inférieur (S2), et la couche de référence (M).

**19.** Procédé d'écriture selon l'une quelconque des revendications 1 à 18, dans lequel les couches magnétiques supérieures et inférieures (M1, M2) sont écrites comme (1,1) et (0,0) en utilisant un événement d'écriture unique, et (1,0) et (0,1) en utilisant deux événements d'écriture.

**20.** Procédé d'écriture selon l'une quelconque des revendications 1 à 19, dans lequel les couches magnétiques supérieure et inférieure (M1, M2) sont écrites comme (1,0) en écrivant d'abord "1" dans les deux couches magnétiques supérieure et inférieure, suivi d'un second événement d'écriture pour écrire "0" dans la couche magnétiquement moins dure (M1, M2).

**21.** Procédé d'écriture selon l'une quelconque des revendications 1 à 20, dans lequel les couches magnétiques supérieure et inférieure (M1, M2) sont écrites comme (0,1) en écrivant d'abord "0" dans les deux couches magnétiques supérieure et inférieure, suivi d'un second événement d'écriture pour écrire "1" dans la couche magnétiquement moins dure (M1, M2).

**22.** Procédé d'écriture selon l'une quelconque des revendications 1 à 21, comprenant en outre le fait de créer une anisotropie unidirectionnelle orthogonale dans l'une des couches magnétiques supérieure et inférieure (M1, M2).

**23.** Procédé d'écriture selon l'une quelconque des revendications 1 à 22, comprenant en outre la création d'un axe de piégeage par magnétisation de la couche de référence (M) orthogonal au grand axe de la cellule de mémoire.

**24.** Mémoire magnétique à accès aléatoire, comprenant :

un dispositif de commutation (Tr) ;
un support d'enregistrement magnétique (10) relié au dispositif de commutation (Tr) ;
une première unité de génération de champ magnétique (20) installée entre le dispositif de commutation (Tr) et le support d'enregistrement magnétique (10) ; et
une seconde unité de génération de champ magnétique (32) reliée au support d'enregistrement magnétique (10),

dans laquelle le support d'enregistrement magnétique (10) comprend :

des couches magnétiques supérieure (M1) et inférieure (M2) qui peuvent être changées magnétiquement et qui sont empilées séquentiellement sur une couche piégée (M) ayant une direction de magnétisation fixe ;

**caractérisée par le fait que** la mémoire magnétique à accès aléatoire est agencée de façon à écrire des données en utilisant un procédé selon l'une quelconque des revendications 1 à 23.

**25.** Mémoire magnétique selon la revendication 24, comprenant en outre une troisième couche magnétique sur la couche magnétique supérieure, dans laquelle les couches magnétiques supérieure et troisième sont séparées l'une de l'autre par une troisième couche séparatrice.

**26.** Mémoire magnétique selon l'une des revendications 24 ou 25, dans laquelle les couches magnétiques supérieure et inférieure (M1, M2) sont constituées de matériaux ferromagnétiques différents.

**27.** Mémoire magnétique selon l'une quelconque des revendications 24 à 26, dans laquelle les couches magnétiques supérieure et inférieure ont des épaisseurs différentes.

**28.** Mémoire magnétique selon l'une quelconque des revendications 24 à 27, dans laquelle les couches magnétiques supérieure et inférieure (M1, M2) ont des anisotropies magnéto cristallines différentes.

29. Mémoire magnétique selon l'une quelconque des revendications 24 à 28, dans laquelle les couches magnétiques supérieure et inférieure (M1, M2) comprennent un élément parmi une anisotropie magnéto cristalline dans le plan, une anisotropie magnéto cristalline hors du plan, et une combinaison d'une anisotropie magnéto cristalline dans le plan et d'une anisotropie magnéto cristalline hors du plan.

30. Mémoire magnétique selon l'une des revendications 24 à 29, dans laquelle les couches magnétiques supérieure et inférieure (M1, M2) sont constituées d'un alliage de Ni, Fe et Co, ou d'une combinaison de ceux-ci.

31. Mémoire magnétique selon l'une quelconque des revendications 24 à 30, dans laquelle chacune des couches magnétiques supérieure et inférieure (M1, M2) est agencée de façon à stocker un bit d'information binaire.

32. Mémoire magnétique selon l'une quelconque des revendications 24 à 31, dans laquelle les couches magnétiques supérieure et inférieure (M1, M2) ont des fréquences de précession de spin différentes.

33. Mémoire magnétique selon l'une quelconque des revendications 24 à 32, dans laquelle la cellule formée par les couches magnétiques (M1, M2) et séparatrices (S1, S2) comporte des extrémités arrondies pour supprimer la nucléation des domaines magnétiques.

34. Mémoire magnétique selon l'une quelconque des revendications 24 à 33, dans laquelle la cellule formée par les couches magnétiques et séparatrices (M1, M2, S1, S2) a un rapport d'aspect dans une plage d'environ 1,1 à 5,0.

35. Mémoire magnétique selon l'une quelconque des revendications 24 à 34, dans laquelle les couches magnétiques supérieure et inférieure (M1, M2) ont des magnétisations de saturation différentes.

36. Mémoire magnétique selon l'une quelconque des revendications 24 à 35, dans laquelle les couches magnétiques supérieures et inférieures (M1, M2) sont des couches d'un matériau magnétique identique, dans laquelle une couche de couverture (C) augmentant la constante d'affaiblissement de Gilbert est réalisée sur la couche magnétique supérieure.

37. Mémoire magnétique selon l'une quelconque des revendications 24 à 36, comprenant en outre une couche de couverture (C) sur la couche magnétique supérieure (M1).

38. Mémoire magnétique selon l'une quelconque des revendications 24 à 37, dans laquelle les séparateurs supérieur et inférieur (S1, S2) ont des épaisseurs différentes.

39. Mémoire magnétique selon l'une quelconque des revendications 24 à 38, dans laquelle les séparateurs supérieur et inférieur (S1, S2) sont constitués de matériaux différents.

40. Mémoire magnétique selon l'une quelconque des revendications 24 à 39, dans laquelle les séparateurs supérieur et inférieur (S1, S2) ont des magnétisations de saturation différentes.

41. Mémoire magnétique selon l'une quelconque des revendications 24 à 40, dans laquelle les couches magnétiques supérieure et inférieures (M1, M2) ont des magnétisations de saturation différentes.

42. Mémoire magnétique selon la revendication 25, dans laquelle le troisième séparateur est constitué d'un matériau conducteur, d'un matériau non conducteur, ou d'un mélange des matériaux précédents.

43. Mémoire magnétique selon l'une des revendications 25 ou 42, dans laquelle la couche magnétique supérieure, la couche magnétique inférieure, et la troisième couche magnétique ont des magnétisations de saturation différentes.

44. Mémoire magnétique selon l'une des revendications 25, 42 ou 43, comprenant en outre une couche de couverture augmentant la constante d'affaiblissement de Gilbert sur la troisième couche magnétique.

45. Mémoire magnétique selon l'une quelconque des revendications 24 à 44, dans laquelle la première unité de génération de champ magnétique est une ligne de données, et la seconde unité de génération de champ magnétique est une ligne de bit.

46. Mémoire magnétique selon l'une quelconque des revendications 24 à 45, dans laquelle les couches magnétiques supérieure et inférieure sont des couches de matériaux magnétiques créant une magnétisation verticale.

**47.** Mémoire magnétique selon l'une des revendications 25, 42, 43 ou 44, dans laquelle la couche magnétique supérieure, la couche magnétique inférieure, et la troisième couche magnétique sont des couches de matériaux magnétiques créant une magnétisation verticale.

**48.** Mémoire magnétique selon l'une quelconque des revendications 24 à 47, comprenant en outre un filtre générant un courant de polarisation de spin dans ou sur le support d'enregistrement magnétique.

FIG. 1

FIG. 2

## FIG. 3

## FIG. 4

FIG. 5

FIG. 6

· FIG. 7

# FIG. 8

z

Hy Word Line
Hard axis

Hx Bit Line
Easy axis

Hy and Hx field pulse

H

+Hx

-Hx

Time

Ms1

$\theta_1$

Ms2

$\theta_2$

Ms1 > Ms2

Hy = ry (Ny-Nx) Ms2
Hx = rx Hy = rx ry (Ny-Nx) Ms2
Ms1 = R Ms2
Hy is always +y direction
Hx can be + or -
Initial M is in -x direction

→ Anisotropy field Hk1 = (Ny-Nx)Ms1 > Hk2 = (Ny-Nx)Ms2

# FIG. 9

Example: Ms1(CoFe) ~ 1.8 T; Ms2(NiFe) ~ 1.0 T

Hy = Hx     Hy = 2Hx

5nm
300nm
200nm

(Nx, Ny, Nz) ~
(0.02423, 0.03687,
0.93889)
→ (Ny-Nx) Ms2 ~ 126 Oe

R{[1/(1-rx1)] - [1/(1-rx2)]} = Δry

Independent writing window ~ 38 Oe

Δry = 0.3 or 30% of Anisotropy field

Degree

90
80
70  Switching
60
50
40
30
20
10  No Switching
0
0.0    0.5    1.0    1.5    2.0

ry = Hy/(Ny-Nx)Ms2

—— 45°
—— R=1.8, rx=0.5, Theta2
— — R=1.8, rx=0.5, Theta1
—— R=1.8, rx=1, Theta2
— — R=1.8, rx=1, Theta1

# FIG. 10

Precessional Period vs Aspect Ratio For Rectangular & Ellipsoid cell

For example:
CoFe and NiFe
R = 1.8
30% of writing field window

~ 20% cell size deviation

- □ Ellipsoid (Width=200nm, Thick=5nm)
- ○ Rectangular (Width=200nm, Thick=5nm)
- —— $(N_y-N_x)M_s$ for Rectangular
- —— $(N_y-N_x)M_s$ for Ellipsoid

## FIG. 11A

dM/dt

Non selected cell
Hy only

Ms = 1T
Ms = 1.5T

## FIG. 11B

dM/dt

Non selected cell
Hx only

Ms = 1T
Ms = 1.5T

## FIG. 11C

## FIG. 11D

# FIG. 12

ΔR1 ≠ ΔR2

ΔR2 = Rmax2 - Rmin2

ΔR1 = Rmax1 - Rmin1

| Spacer 1 |
| Spacer 2 |

(0, 0)
Rmin1 + Rmin2

| Spacer 1 |
| Spacer 2 |

(1, 0)
Rmin1 + Rmin2 + ΔR2

| Spacer 1 |
| Spacer 2 |

(0, 1)
Rmin1 + Rmin2 + ΔR1 + ΔR2

| Spacer 1 |
| Spacer 2 |

(1, 1)
Rmin1 + Rmin2 + ΔR1

FIG. 13

FIG. 14A

FIG. 14B

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- US 20030209769 A, Nickel
- US 5930164 A, Zhu
- US 5703805 A, Tehrani
- US 6590806 B, Bhattacharyya
- US 20040090844 A
- US 20020175386 A
- US 6717843 B
- US 20040076036 A
- US 20040185045 A